# EUROPEAN PATENT SPECIFICATION

(11) **EP 4 348 837 B1**
(45) Date of publication and mention of the grant of the patent: **02.12.2026**
(21) Application number: 22735753.0
(22) Date of filing: 31.05.2022
(51) Int. Cl.: H03M 7/30, G06N 3/08, G06N 20/20

(54) **BI-DIRECTIONAL COMPRESSION AND PRIVACY FOR EFFICIENT COMMUNICATION IN FEDERATED LEARNING**
BIDIREKTIONALE KOMPRESSION UND PRIVATSPHÄRE FÜR EFFIZIENTE KOMMUNIKATION BEI FÖDERIERTEM LERNEN
COMPRESSION BIDIRECTIONNELLE ET CONFIDENTIALITÉ POUR UNE COMMUNICATION EFFICACE DANS UN APPRENTISSAGE FÉDÉRÉ

(30) Priority: 28.05.2021 GR 20210100355; 26.05.2022 WO PCT/US2022/072599
(43) Date of publication of application: 10.04.2024
(73) Proprietor: QUALCOMM INCORPORATED, San Diego, California 92121-1714 (US)
(72) Inventor: REISSER, Matthias, San Diego, California 92121-1714 (US); TRIASTCYN, Aleksei, San Diego, California 92121-1714 (US); LOUIZOS, Christos, San Diego, California 92121-1714 (US)
(74) Representative: Carstens, Dirk Wilhelm
(86) International application number: PCT/US2022/072659
(87) International publication number: WO 2022/251885

(56) References cited:
- MATEI MOLDOVEANU ET AL: "On In-network learning. A Comparative Study with Federated and Split Learning", ARXIV.ORG, CORNELL UNIVERSITY LIBRARY, 201 OLIN LIBRARY CORNELL UNIVERSITY ITHACA, NY 14853, 30 April 2021 (2021-04-30), XP081947047
- ALEKSEI TRIASTCYN ET AL: "DP-REC: Private & Communication-Efficient Federated Learning", ARXIV.ORG, CORNELL UNIVERSITY LIBRARY, 201 OLIN LIBRARY CORNELL UNIVERSITY ITHACA, NY 14853, 9 November 2021 (2021-11-09), XP091097192
- GERGELY FLAMICH ET AL: "Compressing Images by Encoding Their Latent Representations with Relative Entropy Coding", ARXIV.ORG, CORNELL UNIVERSITY LIBRARY, 201 OLIN LIBRARY CORNELL UNIVERSITY ITHACA, NY 14853, 4 March 2021 (2021-03-04), XP081897789
- ANONYM: "COMPRESSION WITHOUT QUANTIZATION", OPENREVIEW, 25 November 2019 (2019-11-25), pages 1 - 16, XP055961334, Retrieved from the Internet <URL:https://openreview.net/pdf?id=HyeG9lHYwH> [retrieved on 20220915]
- BROWNLEE JASON: "How to Avoid Exploding Gradients With Gradient Clipping", 19 July 2019 (2019-07-19), pages 1 - 17, XP055961511, Retrieved from the Internet <URL:https://web.archive.org/web/20190719124952/https://machinelearningmastery.com/how-to-avoid-exploding-gradients-in-neural-networks-with-gradient-clipping/> [retrieved on 20220915]

## Description

### CROSS-REFERENCE TO RELATED APPLICATIONS

This Application claims priority to PCT Application No. PCT/US2022/072599, filed on May 26, 2022, as well as the benefit of and priority to Greek Patent Application No. 20210100355, filed on May 28, 2021.

### INTRODUCTION

Aspects of the present disclosure relate to machine learning.

Machine learning is generally the process of producing a trained model (e.g., an artificial neural network, a tree, or other structures), which represents a generalize fit to a set of training data that is known a priori. Applying the trained model to new data produces inferences, which may be used to gain insights into the new data.

As the use of machine learning has proliferated in various technical domains for what are sometimes referred to as artificial intelligence tasks, the need for more efficient processing of machine learning model data has arisen. For example, "edge processing" devices, such as mobile devices, always on devices, internet of things (IoT) devices, and the like, have to balance the implementation of advanced machine learning capabilities with various interrelated design constraints, such as packaging size, native compute capabilities, power store and use, data communication capabilities and costs, memory size, heat dissipation, and the like.

Federated learning is a distributed machine learning framework that enables a number of clients, such as edge processing devices, to train a shared global model collaboratively without transferring their local data to a remote server. Generally, a central server coordinates the federated learning process and each participating client communicates only model parameter information with the central server while keeping its local data private. This distributed approach helps with the issue of client device capability limitations (because training is federated), and also mitigates data privacy concerns in many cases.

Even though federated learning generally limits the amount of model data in any single transmission between server and client (or vice versa), the iterative nature of federated learning still generates a significant amount of data transmission traffic during training, which can be significantly costly depending on device and connection types. It is thus generally desirable to try and reduce the size of the data exchange between server and clients during federated learning. However, conventional methods for reducing data exchange have resulted in poorer resulting models, such as lossy compression of model data is used to limit the amount of data exchanged between server and clients. Further, conventional federated learning has shown to not preserve privacy.

Accordingly, there is a need for improved methods of performing federated learning where model performance is not compromised in favor of communications efficiency, and where privacy is improved.
Attentions is drawn to MATEI MOLDOVEANU ET AL, "On In-network learning. A Comparative Study with Federated and Split Learning", ARXIV.ORG, CORNELL UNIVERSITY LIBRARY, 201 OLIN LIBRARY CORNELL UNIVERSITY ITHACA, NY 14853, (20210430), XP081947047, relating to Federated and Split Learning.
Further attention is drawn to GERGELY FLAMICH ET AL, "Compressing Images by Encoding Their Latent Representations with Relative Entropy Coding", ARXIV.ORG, CORNELL UNIVERSITY LIBRARY, 201 OLIN LIBRARY CORNELL UNIVERSITY ITHACA, NY 14853, (20210304), XP081897789, relating to compressing images by encoding their latent representations with relative entropy coding.
Additional attention is drawn to Anonym, "COMPRESSION WITHOUT QUANTIZATION", Openreview, (20191125), pages 1 - 16, URL: https://openreview.net/pdf?id=HyeG91HYwH, (20220915), XP055961334, relating to a framework for lossy image compression able to circumvent the quantization step by relying on a non-deterministic compression codec.
Attention is also drawn to Brownlee Jason, "How to Avoid Exploding Gradients With Gradient Clipping", (20190719), pages 1 - 17, URL: https://web.archive.org/web/20190719124952/https://machinelearningmastery.com/how -to-avoid-exploding-gradients-in-neural-networks-with-gradient-clipping/, (20220915), XP055961511, relating to improve neural network training stability using gradient clipping.

### BRIEF SUMMARY

The invention is defined by the appended independent claims. Further embodiments are defined by the appended dependent claims. Certain aspects provide a method for performing federated learning, including receiving a global model from a federated learning server; determining an updated model based on the global model and local data; and sending the updated model to the federated learning server using relative entropy coding.

Further aspects provide a method for performing federated learning, comprising: sending a global model to a client device; determining a random seed; receiving an updated model from the client device using relative entropy coding; and determining an updated global model based on the updated model from the client device.

Other aspects provide processing systems configured to perform the aforementioned methods as well as those described herein; non-transitory, computer-readable media comprising instructions that, when executed by one or more processors of a processing system, cause the processing system to perform the aforementioned methods as well as those described herein; a computer program product embodied on a computer readable storage medium comprising code for performing the aforementioned methods as well as those further described herein; and a processing system comprising means for performing the aforementioned methods as well as those further described herein.

The following description and the related drawings set forth in detail certain illustrative features of one or more aspects.

### BRIEF DESCRIPTION OF THE DRAWINGS

The appended figures depict certain aspects of the one or more aspects and are therefore not to be considered limiting of the scope of this disclosure.
**FIG. 1** depicts an example federated learning architecture.
**FIG. 2A** depicts an example algorithm 1 for the sender side implementation of lossy relative entropy coding.
**FIG. 2B** depicts an example algorithm for the receiver side implementation of lossy relative entropy coding.
**FIG. 3** is a schematic diagram of performing relative entropy encoding to a federated learning update.
**FIG. 4** depicts an example server-side algorithm for applying relative entropy encoding to federated learning.
**FIG. 5** depicts an example client-side algorithm for applying relative entropy encoding to federated learning.
**FIG. 6A** depicts an example client-side algorithm for applying differentially private relative entropy encoding to federated learning.
**FIG. 6B** depicts an example server-side algorithm for applying differentially private relative entropy encoding to federated learning.
**FIG. 7** is a schematic diagram of performing differentially private relative entropy encoding to a federated learning update.
**FIG. 8** depicts an example method for performing federated learning in accordance with aspects described herein.
**FIG. 9** depicts another example method for performing federated learning in accordance with aspects described herein.
**FIGS. 10A** and **10B** depict example processing systems that may be configured to perform the methods described herein.

To facilitate understanding, identical reference numerals have been used, where possible, to designate identical elements that are common to the drawings. It is contemplated that elements and features of one aspect may be beneficially incorporated in other aspects without further recitation.

### DETAILED DESCRIPTION

Aspects of the present disclosure provide apparatuses, methods, processing systems, and non-transitory computer-readable mediums for machine learning, and in particular for bi-directional compression for efficient and private communication in federated learning.

The performance of modern neural network based machine learning models scales extremely well with the amount of data on which they have been trained. At the same time, industry, legislators, and consumers have become more conscious about the need for protecting the privacy of data that might be used in training such models. Federated learning describes a machine learning principle that aims to enable learning on decentralized data by computing updates on-device. Instead of sending its data to a central location, a "client" in a federation of devices sends model updates computed on its data to the central server. Such an approach to learning from decentralized data promises to unlock the computing capabilities of billions of "edge"-devices, enable personalized models, and new applications in, for example healthcare, due to the inherently more private nature of the approach.

On the other hand, the federated learning paradigm brings challenges along many dimensions, such as learning from non-independent and identically distributed data, resource-constrained devices, heterogeneous compute and communication abilities, questions of fairness and representation, as well as communication overhead. In particular, because neural networks require many passes over the data, repeated communications of the most recent server-side model to the client and its update back to the server are necessary, which significantly increases communication overhead. Consequently, compressing updates in federated learning is an important step in reducing such overhead and, for example, "untethering" edge-devices from Wi-Fi.

Conventional approaches to mitigate this problem include compression of the uplink and/or downlink messages via either quantization or pruning of the messages to be sent. However, these techniques may lead to data loss and reduced performance of the trained global model.

To overcome these technical problems with conventional approaches, aspects described herein implement a compression scheme, relative entropy coding, for sending a model and model updates between a client and a server, and vice versa, which does not rely on quantization or pruning, and which is adapted to work for the federated learning setting.

In aspects described herein, the client to server communication may be realized by a series of steps. In one example, the server and the client first agree on a specific random seed *R* and prior distribution *p* (e.g., the last model that the server sent to the client). Then, the client forms a probability distribution *q* centered over the model update it wants to send to the server. Then, the client draws *K* random samples from *p* according to the random seed *R*. Notably, *K* can be determined by the data via measuring the discrepancy between *p* and *q*. Then, the client assigns a probability *πₖ* to each of these *K* samples that is proportional to the ratio $\frac{q}{p}$. Then, the client selects a random sample according to *π*₁, ..., *π_{K}* and records its index *k*. The client then communicates the index *k* to the server with log₂ *K* bits. The server can decode the message by drawing random samples from *p* using the random seed *R*, up until it recovers the *k*'th random sample.

Notably, this procedure can be flexibly implemented. For example, the procedure can be performed parameter-wise (e.g., communicating log₂ *K* bits per parameter), layer-wise (e.g., communicating log₂ *K* bits for each layer in the network), or even network-wise (e.g., communicating log₂ *K* bits overall). Any arbitrary intermediate vector size is possible.

In aspects described herein, the server to client communication is likewise compressible. Initially, the server keeps track of the last time that each client has been selected to participate in training, along with all the model updates it has received from the clients. Then, whenever a client is selected to participate in a round (or instance) of federated learning, the server, instead of sending the current state of the global model, communicates all the model updates necessary in order to update the old local global model copy at the client to the current one. Since each of the model updates can be generated by a specific random seed *R* and log₂ *K* bits, the overall message length can be drastically smaller compared to sending the entire floating point model, especially when aggressive compression is used for the client to server model updates, as described above. Notably, it is always possible to compare the two message sizes (communicating the model in floating point vs. communicating the compressed past model updates) and choose the format with the lower cost.

As above, aspects described herein beneficially work without imposing quantization / pruning on the messages being sent between client and server. Moreover, the compression rate when using the aspects described herein can be much higher than traditional scalar quantization, especially when performing the scheme on a per layer basis. Further yet, the bit-width of the message can beneficially be determined / adapted on the fly.

Aspects described herein thus provide a technical solution to the technical problem described above with respect to communication overhead. Aspects described herein beneficially improve the performance of any devices participating in federated learning, such as by reducing total communication cost, such as how many units (e.g., GB) of data have been communicated between the clients and the server during federated learning. The communication costs can be drastically smaller compared to traditional scalar compression methods, especially when per-layer compression is used in accordance with the methods described herein.

Further aspects described herein relate to improving privacy while performing the aforementioned communication-efficient federated learning. While federated learning provides an intuitive and practical notion of privacy through keeping data on-device, client updates have nevertheless been shown to reveal sensitive information, even allowing the reconstruction of a client's training data. Conventional approaches have generally traded off between limited compression with more privacy, or vice versa, but conventional approaches have not accomplished both simultaneously.

Aspects described herein, on the other hand, may implement a modified relative entropy coding in the federated learning context to be differentially private. In doing so, aspects described herein provide a differentially private federated learning algorithm that achieves extreme compression of client-to-server updates (e.g., down to 7 bits per tensor) at privacy-levels (*ε* < 1, where *ε* quantifies how private the learning algorithm is, meaning how easily could a hypothetical adversary identify where an individual and their data participated in training the model) with a minimal impact on model performance.

Accordingly, aspects described herein provide a concurrent solution to privacy and communication efficiency using differentially private and coding efficient compression of the messages communicated during federated learning.

### Example of Federated Learning Architecture

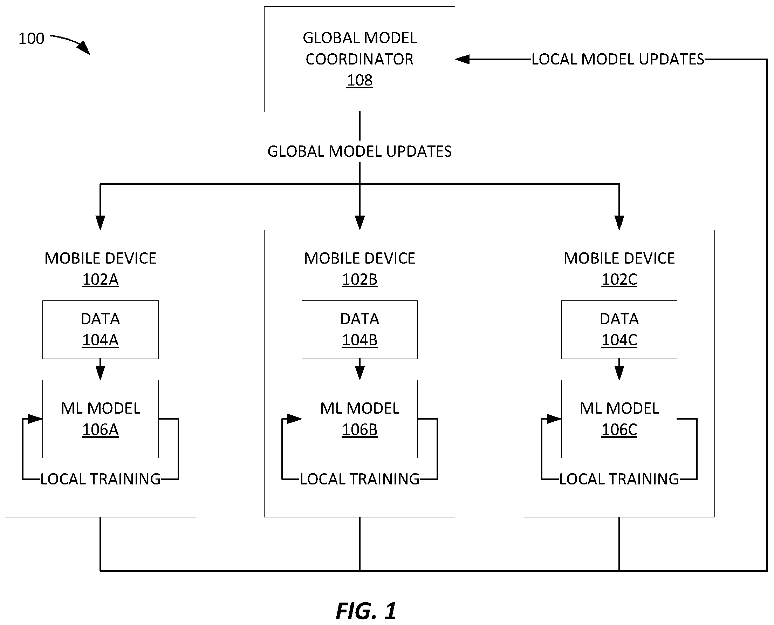

**FIG. 1** depicts an example federated learning architecture 100.

In this example, mobile devices 102A-C, which are examples of edge processing devices, each have a local data store 104A-C, respectively, and a local machine learning model instance 106A-C, respectively. For example, mobile device 102A comes with an initial machine learning model instance 106A (or receives an initial machine learning model instance 106A from, for example, global machine learning model coordinator 108), which may be a software provider in some examples. Each of mobile devices 102A-C may use its respective machine learning model instance (106A-C) for some useful task, such as processing local data 104A-C, and further perform local training and optimization of its respective machine learning model instance.

For example, mobile device 102A may use its machine learning model 106A for performing facial recognition on pictures stored as data 102B on mobile device 102A. Because these photos may be considered private, mobile device 102A may not want to, or may be prevented from sharing its photo data with global model coordinator 108. However, mobile device 102A may be willing or permitted to share its local model updates, such as updates to model weights and parameters, with global model coordinator 108. Similarly, mobile devices 102B and 102C may use their local machine learning model instances, 106B and 106C, respectively, in the same manner and also share their local model updates with global model coordinator 108 without sharing the underlying data used to generate the local model updates.

Global model coordinator 108 (alternatively referred to as a federated learning server) may use all of the local model updates to determine a global (or consensus) model update, which may then be distributed to mobile devices 102A-C. In this way, machine learning can leverage mobile device 102A-C without centralizing training data and processing.

Thus, federated learning architecture 100 allows for decentralized deployment and training of machine learning models, which may beneficially reduce latency, network use, and power consumption while maintaining data privacy and security. Further, federated learning architecture 100 allows for models to evolve differently on different devices, but to ultimately combine that distributed learned knowledge back into a global model.

Notably, the local data stored on mobile devices 102A-C and used by machine learning models 106A-C, respectively, may be referred to as individual data shards (e.g., data 104A-C) and/or federated data. Because these data shards are generated on different devices by different users and are never comingled, they cannot be assumed to be independent and identically distributed (IID) with respect to each other. This is true more generally for any sort of data specific to a device that is not combined for training a machine learning model. Only by combining the individual data sets 104A-C of mobile devices 102A-C, respectively, could a global data set be generated wherein the IID assumption holds.

### Federated Learning, Generally

Federated learning has been described in the form of the FedAvg algorithm, which is described as follows. At each communication round *t*, a server (e.g., 108 in **FIG. 1**) sends the current model parameters w^{(*t*)} to a subset *S'* of all *S* clients participating in training (e.g., mobile devices 102A, 102B, and/or 102C in **FIG. 1**). Each chosen client s updates the server-provided model w^{(*t*)}, for example, via stochastic gradient descent, to better fit its local dataset *Dₛ* (e.g., data 104A, 104B, and/or 104C, respectively, in **FIG. 1**) of size *Nₛ* using a given loss function, such as: ${L}_{s} \left({D}_{s}, w\right) : = \frac{1}{{N}_{s}} {\sum }_{i = 1}^{{N}_{s}} L \left({d}_{si}, w\right) .$ (1)

After *E* epochs of optimization on the local dataset, the client-side optimization procedure results in an updated model ${w}_{s}^{\left(t\right)}$, based on which the client computes its update to the global model according to: ${Δ}_{s}^{\left(t\right)} = {w}_{s}^{\left(t\right)} - {w}^{\left(t\right)} ,$ (2)
and communicates it to the server. The server then aggregates the client specific updates to receive the new global model at the next round according to: ${w}^{\left(t+1\right)} = {w}^{\left(t\right)} + \frac{1}{\left|S′\right|} {\sum }_{s} {Δ}_{s}^{\left(t\right)} = \frac{1}{\left|S′\right|} {\sum }_{s} {w}_{s}^{\left(t\right)} .$ (3)

A generalization of this server-side averaging scheme interprets $\frac{1}{S ′} {\sum }_{s} {Δ}_{s}^{\left(t\right)}$as a "gradient" for the server-side model and introduces more advanced updating schemes, such as adaptive momentum (e.g., the Adam algorithm).

Federated training involves repeated communication of model updates from clients to the server and vice versa. The total communication cost of this procedure can be significant, thus typically constraining federated learning to the use of unmetered channels, such as Wi-Fi networks. Compression of the communicated messages therefore plays an important role in moving federated learning to a truly mobile use-case. To this end, aspects described herein extend the lossy version of relative entropy coding (REC) to the federated setting in order to compress client-to-server model updates, e.g., ${w}_{s}^{\left(t\right)} - {w}^{\left(t\right)}$ .

### Relative Entropy Coding

Lossy relative entropy coding, and its predecessor minimal random code learning, have been originally proposed as a way to compress a random sample w from a distribution *q_{ϕ}*(w) parameterized with *ϕ*, *i.e.,* w ~ *q_{ϕ}*(w), by using information that is "shared" between the sender and the receiver. This information is given in terms of a shared prior distribution *p**_{θ}***(w) with parameters *θ* along with a shared random seed *R*.

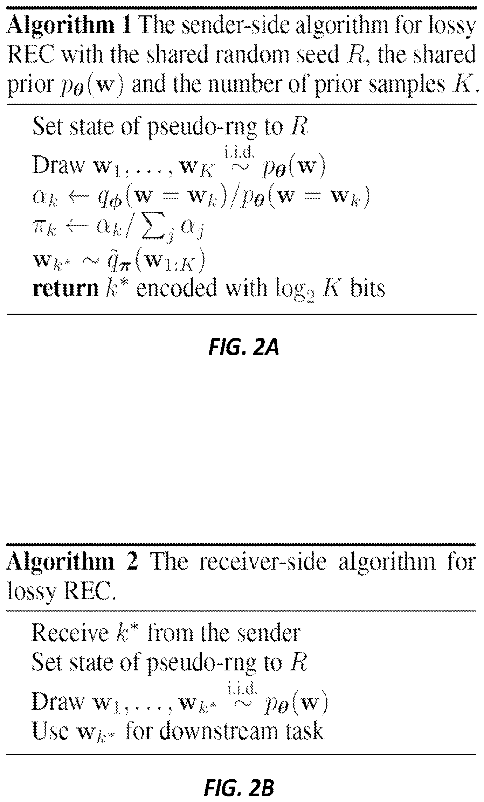

The sender proceeds by generating *K* independent random samples, w₁, ..., w*_{K}* , from the prior distribution *p_{θ}*(w) according to the random seed *R* . Subsequently, it forms a categorical distribution *q̃_{π}*(w_{1:*K*}) over the *K* samples with the probability of each sample being proportional to the likelihood ratio *πₖ* ∝ *q_{ϕ}*(w = w*ₖ*)/*p_{θ}*(w = w*ₖ*). Finally, it draws a random sample w_{*k**} from *q̃_{π}*(w_{1:*K*}), corresponding to the *k**'th sample drawn from the shared prior. The sender can then communicate to the receiver the *index k** with log₂*K* bits. **FIG. 2A** depicts an example Algorithm 1 for the sender side implementation of lossy relative entropy coding.

On the receiver side, w_{*k**} can be reconstructed by initializing the random number generator with *R* and sampling *p_{θ}*(w) up until the *k**'th sample. **FIG. 2B** depicts an example Algorithm 2 for the receiver side implementation of lossy relative entropy coding.

In some cases, *K* may be set equal to the exponential of the Kullback-Leibler (KL) divergence of *q_{ϕ}*(w) to the prior *p_{θ}*(w) with an additional constant *t*, *i.e*., $K = exp \left(\left⌈KL\left({q}_{ϕ}\left(w\right)\left‖{p}_{θ}\left(w\right)\right.\right)\right⌉+t\right)$ . In this case, the message length is at least 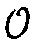 (KL(q*_{ϕ}*(w)∥*p*_{θ}(w))). Thus, when the sender and the receiver share a source of randomness, under some assumptions, this KL divergence is a lower bound to the expected length of the communicated message.

This brings forth an intuitive notion of compression that relates the compression rate with the amount of additional information encoded in *q_{ϕ}*(w) relative to the information in *p_{θ}*(w). Thus, the smaller the amount of extra information, the shorter the message length will be and, in the extreme case where *q_{ϕ}*(w) = *p_{θ}*(w), the message length will be 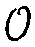 (1). Of course, achieving this efficiency is meaningless if the bias of this procedure is high; fortunately it has been shown that for appropriate values of *t* and under mild assumptions, the bias, namely $\left|{E}_{{{q}^{˜}}_{π} \left({w}_{1 : K}\right)}\left[f\right]-{E}_{{q}_{ϕ} \left(w\right)}\left[f\right]\right|$ for arbitrary functions *f*, can be sufficiently small. Accordingly, in some aspects, *K* may be parameterized as a function of a binary bit-width b, e.g., *K* = 2*^{b}*, and *b* may be treated as a hyperparameter.

### Relative Entropy Coding for Efficient Communications in Federated Learning

Aspects described herein adapt lossy relative entropy coding to the federated setting by appropriately choosing the distribution over the client-to-server messages, e.g., model updates, ${q}_{{ϕ}_{s}}^{\left(t\right)} \left({Δ}_{s}^{\left(t\right)}\right)$, along with the prior distribution ${p}_{θ}^{\left(t\right)} \left({Δ}_{s}^{\left(t\right)}\right)$ on each round *t*. These may be defined as: ${p}_{θ}^{\left(t\right)} \left({Δ}_{s}^{\left(t\right)}\right) : = N \left({Δ}_{s}^{\left(t\right)}\left|0, {σ}^{2}I\right.\right) , {q}_{{ϕ}_{s}}^{\left(t\right)} \left({Δ}_{s}^{\left(t\right)}\right) : = N \left({Δ}_{s}^{\left(t\right)}\left|{w}_{s}^{\left(t\right)}-{w}^{\left(t\right)}, {σ}^{2}I\right.\right) .$ (4)

In other words, a Gaussian distribution centered at zero is used for the prior with appropriately chosen *σ*, and a Gaussian with the same standard deviation centered at the model update is used for the message distribution. The form of *q* is chosen so that implementation is possible on resource constrained devices, as well as in order to satisfy the differential privacy constrains, discussed below. Note that, as opposed to the FedAvg client update definition in Equation (2), here ${Δ}_{s}^{\left(t\right)}$ is considered to be a random variable, and the difference ${w}_{s}^{\left(t\right)} - {w}^{\left(t\right)}$ is considered to be the mean of the client-update distribution *q* over ${Δ}_{s}^{\left(t\right)}$.

The length of the a client-to-server federated learning message will thus be a function of how much "extra" information about the local dataset *Dₛ* is encoded into ${w}_{s}^{\left(t\right)}$, measured via the KL-divergence. This has a nice interplay with differential privacy (DP) because differential privacy constraints bound the amount of information encoded in each update, resulting in highly compressible messages. It is also notably that this procedure can be done parameter-wise (e.g., communicating log₂*K* bits per parameter), layer-wise (e.g. communicating log₂*K* bits for each layer in the global model), or even network-wise (e.g., communicating log₂*K* bits total). Any arbitrary intermediate vector size is also possible. This is realized by splitting ${q}_{ϕ}^{\left(t\right)} \left({Δ}_{s}^{\left(t\right)}\right) , {p}_{θ}^{\left(t\right)} \left({Δ}_{s}^{\left(t\right)}\right)$ to *M* independent groups (which is straightforward due to the assumption of factorial distributions over the dimensions of the vector) and applying the compression mechanism independently to each group.

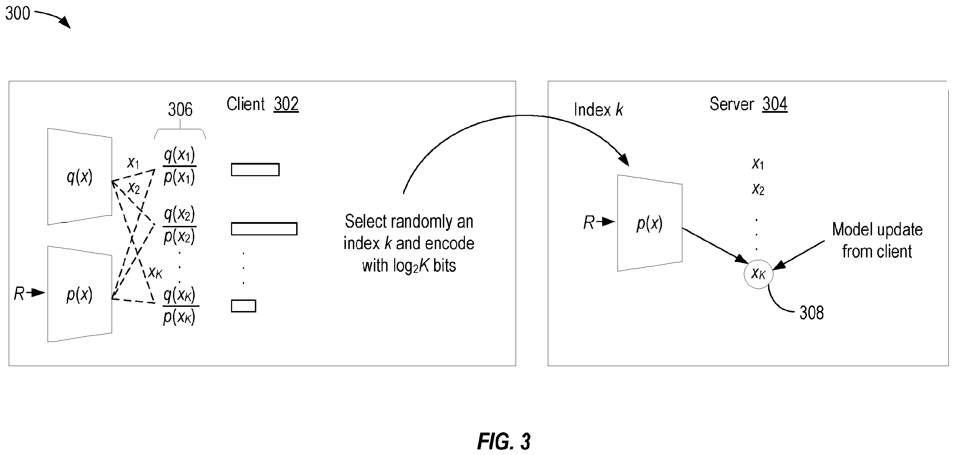

**FIG. 3** depicts schematically an example 300 of a client 302 to server 304 communication. In the depicted example, client 302 generates samples 1 to *k* based on ratios 306 of the distribution *q_{ϕ}* and the shared prior distribution *p_{θ}* (described above). Then an index *k* is transmitted from client 302 to the sever 304, and server 304 is then able to recover the model update 308 based on decoding the index with shared information, such as the shared prior distribution *p_{θ}* and the random seed, *R*.

The compression procedure described with respect to the client-to-server federated learning messaging is a specific example of (stochastic) vector quantization, where the shared codebook is determined by a shared random seed, *R*. Beneficially, the principle of communicating indices into such a shared codebook additionally allows for the compression of the server-to-client communication.

For example, instead of sending the full server-side model to a specific client, the server can choose to collect all updates to the global model in-between two subsequent rounds in which the client participates. Based on this history of codebook indices, the client can deterministically reconstruct the current state of the server model before beginning local optimization.

Clearly, the expected length of the history is proportional to the total number of clients and the amount of client subsampling performed during training. At the beginning of any round, the server can therefore compare the bit-size of a client's history and choose to send the full-precision model w^{(*t*)} instead. Taking a model with 1*k* parameters as an example, a single uncompressed model update is approximately equal to 4*k* communicated indices when using 8-bit codebook compression of the whole model. Crucially, compressing server-to-client messages this way has no influence on the differentially private nature of the aspects described below because any information released from a client is private according to those aspects.

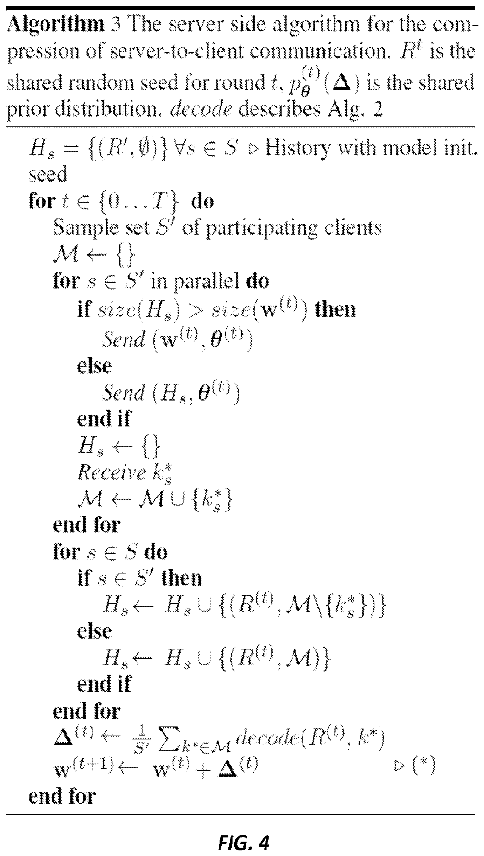

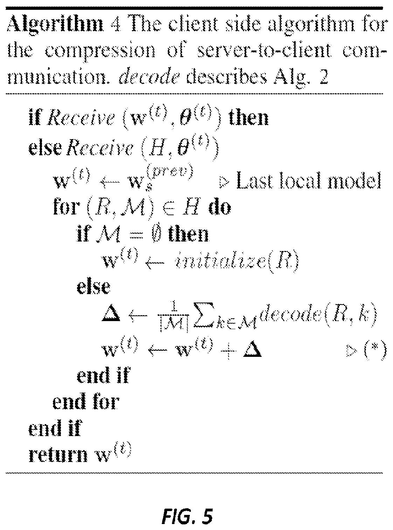

For clients participating in their first round of training, the first seed without accompanying indices can be understood as seeding the random initialization of the server-side model. Algorithms 3 and 4, depicted in **FIGS. 4** and **5****,** respectively, give an example of the server side and client side procedures, respectively. Note that the client-side update-rule should be equal to the server-side update rule (*); in other words, in generalized FedAvg, it might be necessary to additionally send the optimizer state when sending the current global model w^{(*t*)}.

### Differentially Private Relative Entropy Coding for Private and Efficient Communications in Federated Learning

The relative entropy coding learning compression scheme described above beneficially allows for significant reduction in communication costs, often by orders of magnitude compared to conventional methods. However, the model updates can still reveal sensitive information about the clients' local data sets, and at least from a theoretical standpoint, the compressed model updates leak as much information as full precision updates.

To mitigate privacy risks, differential privacy may be employed during training. A conventional differential privacy mechanism for federated learning involves each client clipping the norm of the full precision model updates before sending them to the server. The server then averages the clipped model updates, possibly with a secure aggregation protocol, and adds Gaussian noise with a specific variance. However, the conventional application of differential privacy does not work with compression.

Accordingly, various aspects may modify the relative entropy coding learning compression scheme described above to ensure privacy. Specifically, to ensure differential privacy of the relative entropy coding described above, it is necessary to bound its sensitivity to quantify it inherent noise. Bounding the sensitivity consists of clipping the norm of client updates ${w}_{s}^{\left(t\right)} - {w}^{\left(t\right)}$. In the context of relative entropy encoding, this means that the client message distribution ${q}_{ϕ}^{\left(t\right)}$ cannot be too different from the server prior ${p}_{θ}^{\left(t\right)}$ in any given round *t*. Note that explicit injection of additional noise to the updates is not necessary, contrary to conventional methods, because the procedure is itself stochastic. Two sources of randomness play a role in each round *t*: (1) drawing a set of *K* samples from the prior ${p}_{θ}^{\left(t\right)}$; and (2) drawing an update from the importance sampling distribution ${{q}^{˜}}_{π}^{\left(t\right)}$.

Thus, differentially-private relative entropy coding (DP-REC) may generally be accomplished in two steps. First, each client may clip the norm of its model update before forming a probability distribution *q* centered at this clipped update. In one example, the clipping threshold is calibrated according to *σₚ*. The purpose of this step is to ensure the Rényi divergence between the posterior *q* and the server prior *p* is bounded. The boundedness is necessary for being ample to compute the privacy guarantee.

Note that the Rényi divergence of order α or alpha-divergence of a distribution *P* from a distribution *Q* is defined to be: ${D}_{α} \left(P\left‖Q\right.\right) = \frac{1}{α - 1} log \left({\sum }_{i = 1}^{n} \frac{{p}_{i}^{α}}{{q}_{i}^{α - 1}}\right)$ for discrete distributions or ${D}_{α} \left(P\left‖Q\right.\right) = \frac{1}{α - 1} log \left.\int \frac{{p}^{α}}{{q}^{α - 1}} dμ\right)$ for continuous distributions.

Second, the sever records events that leak information about the clients' data. For example, sampling of a particular client from the entire population along with its probability in each round, or sampling from the importance distribution *π_{q}*. These events define probability distributions over possible model updates for all clients. The privacy accounting component uses this information, in combination with the clipping bound, to determine the maximum Rényi divergence between update distributions for any two clients over the course of training, and then computes *ε*, *δ* parameters of differential privacy by employing Chernoff bound. In probability theory, the Chernoff bound gives exponentially decreasing bounds on tail distributions of sums of independent random variables. Further, *ε* declares the degree of "privateness" of a specific algorithm, whereas *δ* (which is usually taken to be sufficiently small) is the probability on differential privacy failing (and thus not giving private outputs).

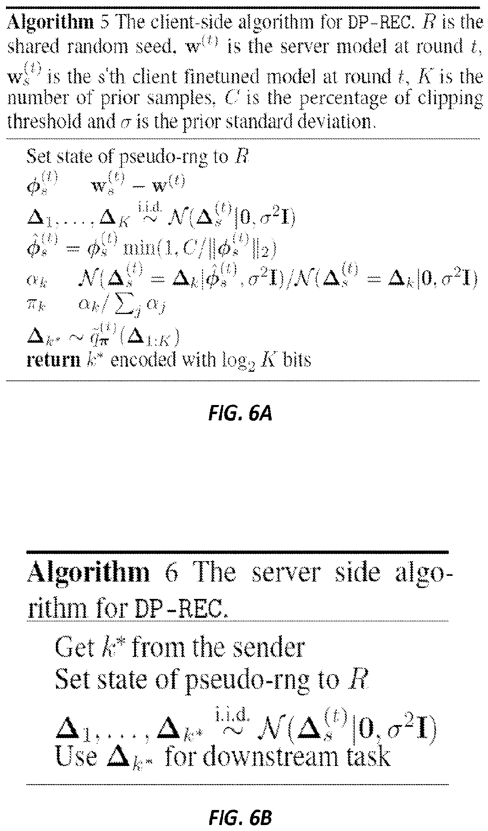

**FIGS. 6A** and **6B** depict Algorithms 5 and 6 for performing differentially-private relative entropy coding (DP-REC) at the client side and server side, respectively.

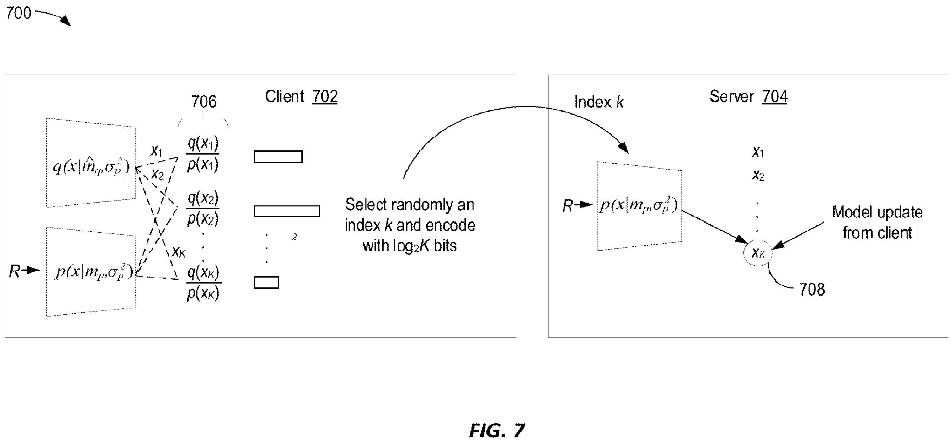

**FIG. 7** depicts schematically an example 700 of a client 702 to server 704 communication. In the depicted example, client 702 generates samples 1 to *k* based on ratios 706 of the distribution ${q}_{ϕ} \left(x\left|{\hat{m}}_{q}, {σ}_{p}^{2}\right.\right)$ and the shared prior distribution ${p}_{θ} \left(x\left|{m}_{p}, {σ}_{p}^{2}\right.\right)$ (described above). However, in this example, the norms are clipped prior to generating the ratios, which generates the clipped model update.

For example, where *m_{q}* is the model update, *m̂_{q}* is the clipped model update calculated according to ${\hat{m}}_{q} = {m}_{q} min \left(1, \frac{Δ {σ}_{p}}{\left‖{m}_{q}\right‖}\right)$, where Δ is the amount of clipping performed.

Then an index *k* is transmitted from client 702 to the sever 704, and server 704 is then able to recover the model update 708 based on decoding the index with shared information, such as the shared prior distribution *p_{θ}* and the random seed, *R*.

Notably, as compared to conventional differential privacy techniques, aspects described herein require no additional noise to be injected into the updates, either at the client or at the server. Rather, the randomness in the relative entropy coding procedure for the federated learning updates is used. Beneficially then, communication efficient federated learning using relative entropy coding can be combined with the privacy preserving aspects of differential privacy for a unified approach.

### Example Methods

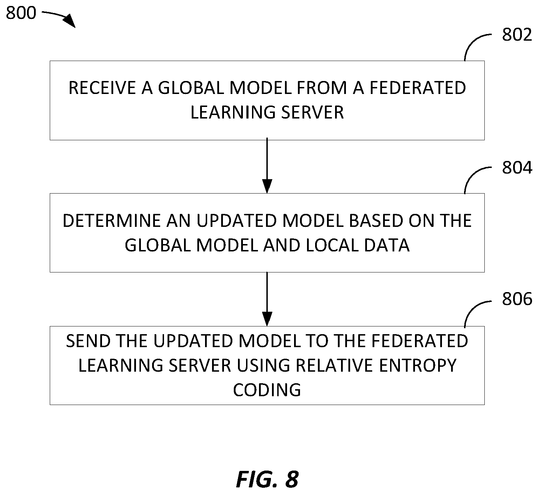

**FIG. 8** depicts an example method 800 for performing federated learning in accordance with aspects described herein. Method 800 may generally be performed by a client in a federated learning scheme, such a mobile device 102 in **FIG. 1****.**

Method 800 beings at step 802 with receiving a global model from a federated learning server, such as global model coordinator 108 in **FIG. 1****.**

Method 800 then proceeds to step 804 with determining an updated model based on the global model and local data. For example, a local machine learning model like 106A in **FIG. 1** may be trained on local data 104A to generate the updated model. Determining the updated model may include generating updated model parameters, such as weights and biases, which may be determined as direct values, or as relative values (e.g., deltas). In some aspects, determining the updated model based on the global model and local data comprises performing gradient descent on the global model using the local data.

Method 800 then proceeds to step 806 with sending the updated model to the federated learning server using relative entropy coding. In some aspects, sending the updated model to the federated learning server using relative entropy coding is performed in accordance with the algorithm depicted and described with respect to **FIG. 5** or **FIG. 6A****.**

In some aspects, sending the updated model to the federated learning server using relative entropy coding comprises determining a random seed. In some aspects, determining the random seed comprises receiving the random seed from the federated learning server. In other aspects, the client may determine the random seed and send it to the federated learning server, which may prevent any manipulation of the random seed by the federated learning server and improve privacy.

In some aspects, sending the updated model to the federated learning server using relative entropy coding further comprises determining a first probability distribution based on the global model and a second probability distribution centered on the updated model

In some aspects, sending the updated model to the federated learning server using relative entropy coding further comprises determining a plurality of random samples from the first probability distribution according to the random seed and assigning a probability to each respective random sample of the plurality of random samples based on a ratio of a likelihood of the respective random sample given the second probability distribution to a likelihood of the respective random sample given the first probability distribution.

In some aspects, determining the plurality of random samples from the first probability distribution according to the random seed is performed based on a difference between the first probability distribution and the second probability distribution. In some cases, the number of random samples (*K*) is computed as *K = exp*(*KL*(*q*∥*p*) *+ t*), where *KL* is the Kulback-Leibler divergence between *q* and *p*, and *t* is an adjustment factor. In other cases, *K* may be computed as = 2*^{b}*, where *b* is the number of bits allowed for a client-to-server message, such as a local model updated as depicted and described with respect to **FIG. 1****.**

Notably, the ratio of a likelihood of the respective random sample given the second probability distribution to a likelihood of the respective random sample given the first probability distribution the ratio can determined parameter-wise, such as: *q*(*w*₁*)*/*p*(*w*₁), *q*(*w*₂)/*p*(*w*₂), etc. The ratio can also be determined for a given number of elements, which may represent, for example, a layer of the model to be updated, such as: (*q*(*w*₁) × *q*(*w*₂) × ... × *q*(*wₖ*))/(*p*(*w*₁) × *p*(*w*₂) × ... × *p*(*wₖ*)). In other words, the parameters 1 to k might represent a layer, or even a whole neural network model, or any arbitrary chunk of the entire set of parameters of the neural network model. Accordingly, n some aspects, the plurality of random samples are associated with a plurality of parameters of the global model. In some aspects, the plurality of random samples are associated with a layer of the global model. In some aspects, the plurality of random samples are associated with a subset of parameters of the global model.

In some aspects, sending the updated model to the federated learning server using relative entropy coding further comprises selecting a random sample of the plurality of random samples according to the probability of each of the plurality of random samples.

In some aspects, sending the updated model to the federated learning server using relative entropy coding further comprises determining an index associated with the selected random sample and sending the index to the federated learning server.

For example, assume there are 8 samples, then there is a probability distribution over these 8 samples, and then a random sample may be drawn from this distributions, representing the index to one of the 8 samples.

In some cases, the index is sent using log₂*K* bits, and *K* is a number of the plurality of random samples from the first probability distribution.

In some aspects, method 800 further includes clipping the updated model prior to determining the second probability distribution centered on the updated model, wherein the clipping is based on a standard deviation of the global model (*σ*), and wherein the second probability distribution is based on the clipped updated model. In one aspect, he clipping value is computed as *C* × *σ*, where *σ* is the prior standard deviation of the global model. The full paper contains these details, at the moment it can be found in line 4 of algorithm 5

In some aspects, clipping the updated model comprises clipping a norm of the updated model.

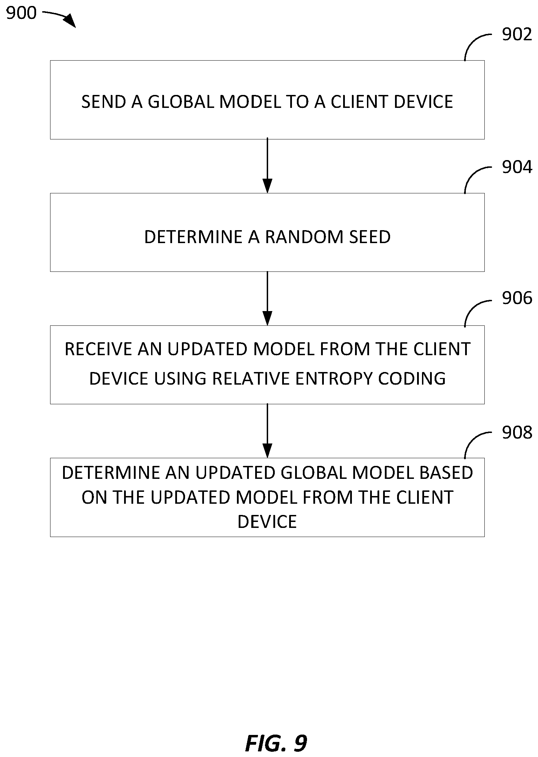

**FIG. 9** depicts an example method 900 for performing federated learning in accordance with aspects described herein. Method 900 may generally be performed by a server in a federated learning scheme, such a global model coordinator 108 in **FIG. 1****.**

Method 900 begins at step 902 with sending a global model to a client device.

Method 900 then proceeds to step 904 with determining a random seed.

Method 900 then proceeds to step 906 with receiving an updated model from the client device using relative entropy coding.

In some aspects, receiving the updated model from the client device using relative entropy coding is performed in accordance with the algorithm depicted and described with respect to **FIG. 4** or **FIG. 6B****.**

Method 900 then proceeds to step 908 with determining an updated global model based on the updated model from the client device.

In some aspects, receiving the updated model from the client device using relative entropy coding comprises: receiving an index from the client device; determining a sample from a probability distribution based on the global model, the random seed, and the index; and using the determined sample to determine the updated global model.

In some aspects, the index is received using log₂*K* bits, and *K* is a number of random samples determined from a probability distribution based on the global model.

In some aspects, the determined sample is used to update a parameter of the updated global model.

In some aspects, the determined sample is used to update a layer of the updated global model.

In some aspects, determining the random seed comprises receiving the random seed from the client device. In other aspects, determining the random seed is performed by the federated learning server, and the federated learning server sends the random seed to the client device.

### Example Processing System for Performing Sparsity-Aware Compute-in-Memory

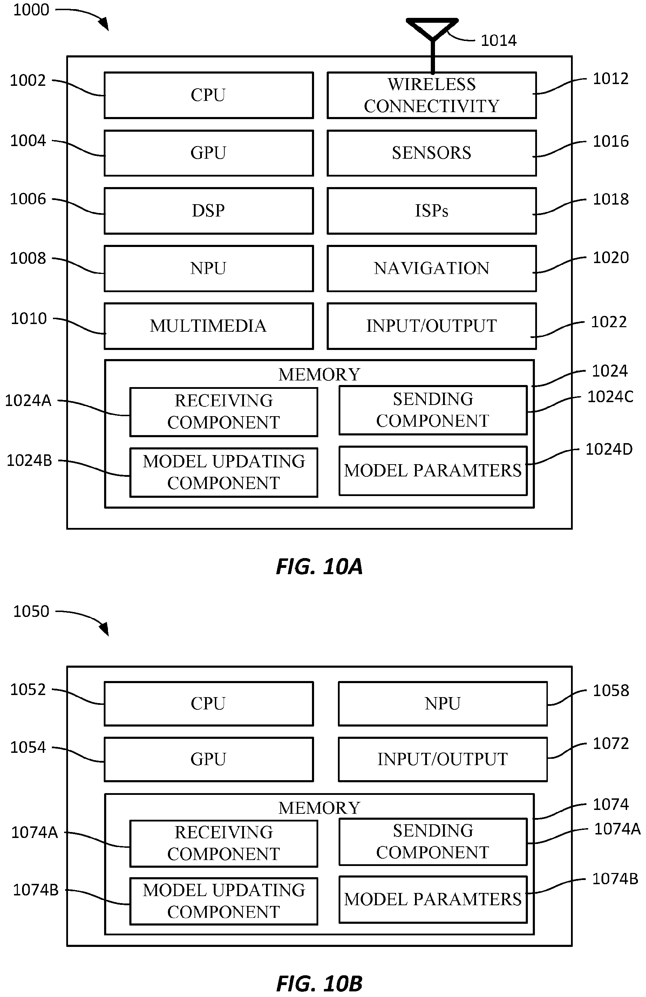

**FIG. 10A** depicts an example processing system 1000 for performing federated learning, such as described herein for example with respect to **FIGS. 1-8****.** Processing system 1000 may be an example of a client device, such as client devices 102A-C in **FIG. 1****.**

Processing system 1000 includes a central processing unit (CPU) 1002, which in some examples may be a multi-core CPU. Instructions executed at the CPU 1002 may be loaded, for example, from a program memory associated with the CPU 1002 or may be loaded from a memory partition 1024.

Processing system 1000 also includes additional processing components tailored to specific functions, such as a graphics processing unit (GPU) 1004, a digital signal processor (DSP) 1006, a neural processing unit (NPU) 1008, a multimedia processing unit 1010, and a wireless connectivity component 1012.

An NPU, such as 1008, is generally a specialized circuit configured for implementing all the necessary control and arithmetic logic for executing machine learning algorithms, such as algorithms for processing artificial neural networks (ANNs), deep neural networks (DNNs), random forests (RFs), and the like. An NPU may sometimes alternatively be referred to as a neural signal processor (NSP), tensor processing units (TPU), neural network processor (NNP), intelligence processing unit (IPU), vision processing unit (VPU), or graph processing unit.

NPUs, such as 1008, are configured to accelerate the performance of common machine learning tasks, such as image classification, machine translation, object detection, and various other predictive models. In some examples, a plurality of NPUs may be instantiated on a single chip, such as a system on a chip (SoC), while in other examples they may be part of a dedicated neural-network accelerator.

NPUs may be optimized for training or inference, or in some cases configured to balance performance between both. For NPUs that are capable of performing both training and inference, the two tasks may still generally be performed independently.

NPUs designed to accelerate training are generally configured to accelerate the optimization of new models, which is a highly compute-intensive operation that involves inputting an existing dataset (often labeled or tagged), iterating over the dataset, and then adjusting model parameters, such as weights and biases, in order to improve model performance. Generally, optimizing based on a wrong prediction involves propagating back through the layers of the model and determining gradients to reduce the prediction error. In some cases, an NPU may be configured to perform the federated learning methods described herein.

NPUs designed to accelerate inference are generally configured to operate on complete models. Such NPUs may thus be configured to input a new piece of data and rapidly process it through an already trained model to generate a model output (e.g., an inference).

In one implementation, NPU 1008 is a part of one or more of CPU 1002, GPU 1004, and/or DSP 1006.

In some examples, wireless connectivity component 1012 may include subcomponents, for example, for third generation (3G) connectivity, fourth generation (4G) connectivity (e.g., 4G LTE), fifth generation connectivity (e.g., 5G or NR), Wi-Fi connectivity, Bluetooth connectivity, and other wireless data transmission standards. Wireless connectivity processing component 1012 is further connected to one or more antennas 1014. In some examples, wireless connectivity component 1012 allows for performing federated learning according to methods described herein over various wireless data connections, including cellular connections.

Processing system 1000 may also include one or more sensor processing units 1016 associated with any manner of sensor, one or more image signal processors (ISPs) 1018 associated with any manner of image sensor, and/or a navigation processor 1020, which may include satellite-based positioning system components (e.g., GPS or GLONASS) as well as inertial positioning system components.

Processing system 1000 may also include one or more input and/or output devices 1022, such as screens, touch-sensitive surfaces (including touch-sensitive displays), physical buttons, speakers, microphones, and the like.

In some examples, one or more of the processors of processing system 1000 may be based on an ARM or RISC-V instruction set.

Processing system 1000 also includes memory 1024, which is representative of one or more static and/or dynamic memories, such as a dynamic random access memory, a flash-based static memory, and the like. In this example, memory 1024 includes computer-executable components, which may be executed by one or more of the aforementioned processors of processing system 1000.

In particular, in this example, memory 1024 includes receiving component 1024A, model updating component 1024B, sending component 1024C, and model parameters 1024D. The depicted components, and others not depicted, may be configured to perform various aspects of the methods described herein.

Generally, processing system 1000 and/or components thereof may be configured to perform the methods described herein.

Notably, in other cases, aspects of processing system 1000 may be omitted or added. For example, multimedia component 1010, wireless connectivity 1012, sensors 1016, ISPs 1018, and/or navigation component 1020 may be omitted in other aspects. Further, aspects of processing system 1000 maybe distributed between multiple devices.

**FIG. 10B** depicts another example processing system 1050 for performing federated learning, such as described herein for example with respect to **FIGS. 1-7** and **9.** Processing system 1050 may be an example of a federated learning server, such as global model coordinator 108 in **FIG. 1****.**

Generally, CPU 1052, GPU 1054, NPU 1058, and input/output 1072 are as described above with respect to like elements in **FIG. 10A****.**

Processing system 1050 also includes memory 1074, which is representative of one or more static and/or dynamic memories, such as a dynamic random access memory, a flash-based static memory, and the like. In this example, memory 1074 includes computer-executable components, which may be executed by one or more of the aforementioned processors of processing system 1050.

In particular, in this example, memory 1074 includes receiving component 1074A, model updating component 1074B, sending component 1074C, and model parameters 1074D. The depicted components, and others not depicted, may be configured to perform various aspects of the methods described herein.

Generally, processing system 1050 and/or components thereof may be configured to perform the methods described herein.

Notably, in other cases, aspects of processing system 1050 may be omitted or added. Further, aspects of processing system 1050 maybe distributed between multiple devices, such as in a cloud-based service. The depicted components are limited for clarity and brevity.

### Example Clauses

Implementation examples are described in the following numbered clauses:
Clause 1: A method, comprising: receiving a global model from a federated learning server; determining an updated model based on the global model and local data; and sending the updated model to the federated learning server using relative entropy coding.
Clause 2: The method of Claim 1, wherein sending the updated model to the federated learning server using relative entropy coding comprises: determining a random seed; determining a first probability distribution based on the global model; determining a second probability distribution centered on the updated model; determining a plurality of random samples from the first probability distribution according to the random seed; assigning a probability to each respective random sample of the plurality of random samples based on a ratio of a likelihood of the respective random sample given the second probability distribution to a likelihood of the respective random sample given the first probability distribution; selecting a random sample of the plurality of random samples according to the probability of each of the plurality of random samples; determining an index associated with the selected random sample; and sending the index to the federated learning server.
Clause 3: The method of Clause 2, wherein determining the plurality of random samples from the first probability distribution according to the random seed is performed based on a difference between the first probability distribution and the second probability distribution.
Clause 4: The method of any one of Clauses 2-3, wherein: the index is sent using log₂*K* bits, and K is a number of the plurality of random samples from the first probability distribution.
Clause 5: The method of any one of Clauses 2-4, wherein the plurality of random samples are associated with a plurality of parameters of the global model.
Clause 6: The method of any one of Clauses 2-4, wherein the plurality of random samples are associated with a layer of the global model.
Clause 7: The method of any one of Clauses 2-4, wherein the plurality of random samples are associated with a subset of parameters of the global model.
Clause 8: The method of any one of Clauses 2-7, further comprising: clipping the updated model prior to determining the second probability distribution centered on the updated model, wherein the clipping is based on a standard deviation of the global model, and wherein the second probability distribution is based on the clipped updated model.
Clause 9: The method of Clause 8, wherein clipping the updated model comprises clipping a norm of the updated model.
Clause 10: The method of any one of Clauses 1-9, wherein determining the updated model based on the global model and local data comprises performing gradient descent on the global model using the local data.
Clause 11: The method of any one of Clauses 2-10, wherein determining the random seed comprises receiving the random seed from the federated learning server.
Clause 12: A method, comprising: sending a global model to a client device; determining a random seed; receiving an updated model from the client device using relative entropy coding; and determining an updated global model based on the updated model from the client device.
Clause 13: The method of Clause 12, wherein receiving the updated model from the client device using relative entropy coding comprises: receiving an index from the client device; determining a sample from a probability distribution based on the global model, the random seed, and the index; and using the determined sample to determine the updated global model.
Clause 14: The method of Clause 13, wherein: the index is received using log₂*K* bits, and K is a number of random samples determined from a probability distribution based on the global model.
Clause 15: The method of any one of Clauses 13-14, wherein the determined sample is used to update a parameter of the updated global model.
Clause 16: The method of any one of Clauses 13-15, wherein the determined sample is used to update a layer of the updated global model.
Clause 17: The method of any one of Clauses 12-16, wherein determining the random seed comprises receiving the random seed from the client device.
Clause 18: A processing system, comprising: a memory comprising computer-executable instructions; and one or more processors configured to execute the computer-executable instructions and cause the processing system to perform a method in accordance with any one of Clauses 1-17.
Clause 19: A processing system, comprising means for performing a method in accordance with any one of Clauses 1-17.
Clause 20: A non-transitory computer-readable medium comprising computer-executable instructions that, when executed by one or more processors of a processing system, cause the processing system to perform a method in accordance with any one of Clauses 1-17.
Clause 21: A computer program product embodied on a computer-readable storage medium comprising code for performing a method in accordance with any one of Clauses 1-17.

### Additional Considerations

The preceding description is provided to enable any person skilled in the art to practice the various aspects described herein. The inventions is defined by the appended claims.

As used herein, the word "exemplary" means "serving as an example, instance, or illustration." Any aspect described herein as "exemplary" is not necessarily to be construed as preferred or advantageous over other aspects.

As used herein, a phrase referring to "at least one of" a list of items refers to any combination of those items, including single members. As an example, "at least one of: a, b, or c" is intended to cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c or any other ordering of a, b, and c).

As used herein, the term "determining" encompasses a wide variety of actions. For example, "determining" may include calculating, computing, processing, deriving, investigating, looking up (e.g., looking up in a table, a database or another data structure), ascertaining and the like. Also, "determining" may include receiving (e.g., receiving information), accessing (e.g., accessing data in a memory) and the like. Also, "determining" may include resolving, selecting, choosing, establishing and the like.

The methods disclosed herein comprise one or more steps or actions for achieving the methods. The method steps and/or actions may be interchanged with one another without departing from the scope of the claims. In other words, unless a specific order of steps or actions is specified, the order and/or use of specific steps and/or actions may be modified without departing from the scope of the claims. Further, the various operations of methods described above may be performed by any suitable means capable of performing the corresponding functions. The means may include various hardware and/or software component(s) and/or module(s), including, but not limited to a circuit, an application specific integrated circuit (ASIC), or processor. Generally, where there are operations illustrated in figures, those operations may have corresponding counterpart means-plus-function components with similar numbering.

The following claims are not intended to be limited to the aspects shown herein, but are to be accorded the full scope consistent with the language of the claims. Within a claim, reference to an element in the singular is not intended to mean "one and only one" unless specifically so stated, but rather "one or more." Unless specifically stated otherwise, the term "some" refers to one or more.

## Claims

1. A computer-implemented method (800), comprising:
receiving (802) a global model from a federated learning server;
determining (804) an updated model based on the global model and local data; and
sending (806) the updated model to the federated learning server using relative entropy coding,
wherein sending the updated model to the federated learning server using relative entropy coding comprises:
determining a random seed comprising receiving the random seed from the federated learning server;
determining a first probability distribution based on the global model;
determining a second probability distribution centered on the updated model;
determining a plurality of random samples from the first probability distribution according to the random seed based on a difference between the first probability distribution and the second probability distribution, wherein the plurality of random samples are associated with a plurality of parameters of the global model;
assigning a probability to each respective random sample of the plurality of random samples based on a ratio of a likelihood of the respective random sample given the second probability distribution to a likelihood of the respective random sample given the first probability distribution;
selecting a random sample of the plurality of random samples according to the probability of each of the plurality of random samples;
determining an index associated with the selected random sample; and
sending the index to the federated learning server.

2. The method of Claim 1, wherein:
the index is sent using log₂*K* bits, and
*K* is a number of the plurality of random samples from the first probability distribution.

3. The method of Claim 1, wherein the plurality of random samples are associated with a layer of the global model.

4. The method of Claim 1, wherein the plurality of random samples are associated with a subset of parameters of the global model.

5. The method of Claim 1, further comprising:
clipping the updated model prior to determining the second probability distribution centered on the updated model,
wherein the clipping is based on a standard deviation of the global model, and
wherein the second probability distribution is based on the clipped updated model.

6. The method of Claim 5, wherein clipping the updated model comprises clipping a norm of the updated model.

7. The method of Claim 1, wherein determining the updated model based on the global model and local data comprises performing gradient descent on the global model using the local data.

8. A computer-implemented method (900), comprising:
sending (902) a global model to a client device;
determining (904) a random seed comprising receiving the random seed from the client device;
receiving (906) an updated model from the client device using relative entropy coding; and
determining (908) an updated global model based on the updated model from the client device,
wherein receiving the updated model from the client device using relative entropy coding comprises:
receiving an index from the client device;
determining a sample from a probability distribution based on the global model, the random seed, and the index; and
using the determined sample to determine the updated global model, wherein the determined sample is used to update a parameter of the updated global model.

9. The method of Claim 8, wherein:
the index is received using log₂*K* bits, and
*K* is a number of random samples determined from a probability distribution based on the global model.

10. The method of Claim 8, wherein the determined sample is used to update a layer of the updated global model.

11. A processing system for performing federated learning, comprising means to cause the processing system to perform a method in accordance with any one of Claims 1-10.

12. The processing system according to claim 11, comprising: a memory comprising computer-executable instructions; and one or more processor configured to execute the computer-executable instructions and cause the processing system to perform the method.

13. A non-transitory computer-readable medium comprising computer-executable instructions that, when executed by one or more processors of a processing system, cause the processing system to perform a method in accordance with any one of Claims 1-10.

14. A computer program product comprising code for performing a method in accordance with any one of Claims 1-10.

## Patentansprüche

1. Ein computerimplementiertes Verfahren (800), das Folgendes aufweist:
Empfangen (802) eines globalen Modells von einem Server für föderiertes Lernen bzw. Federated-Learning-Server;
Bestimmen (804) eines aktualisierten Modells basierend auf dem globalen Modell und lokalen Daten; und
Senden (806) des aktualisierten Modells an den Server für föderiertes Lernen unter Nutzung einer Relativentropiecodierung,
wobei Senden des aktualisierten Modells an den Server für föderiertes Lernen unter Nutzung einer Relativentropiecodierung Folgendes aufweist:
Bestimmen eines Zufalls-Seeds, das Empfangen des Zufalls-Seeds von dem Server für föderiertes Lernen aufweist;
Bestimmen einer ersten Wahrscheinlichkeitsverteilung basierend auf dem globalen Modell;
Bestimmen einer zweiten Wahrscheinlichkeitsverteilung, die auf das aktualisierte Modell zentriert ist;
Bestimmen einer Vielzahl von Zufallsstichproben aus der ersten Wahrscheinlichkeitsverteilung gemäß dem Zufalls-Seed basierend auf einer Differenz zwischen der ersten Wahrscheinlichkeitsverteilung und der zweiten Wahrscheinlichkeitsverteilung, wobei die Vielzahl von Zufallsstichproben einer Vielzahl von Parametern des globalen Modells zugeordnet ist;
Zuweisen einer Wahrscheinlichkeit zu jeder jeweiligen Zufallsstichprobe der Vielzahl von Zufallsstichproben basierend auf einem Verhältnis einer Wahrscheinlichkeit der jeweiligen Zufallsstichprobe gegeben die zweite Wahrscheinlichkeitsverteilung zu einer Wahrscheinlichkeit der jeweiligen Zufallsstichprobe gegeben die erste Wahrscheinlichkeitsverteilung;
Auswählen einer Zufallsstichprobe aus der Vielzahl von Zufallsstichproben gemäß der Wahrscheinlichkeit jeder der Vielzahl von Zufallsstichproben;
Bestimmen eines Index, der mit der ausgewählten Zufallsstichprobe assoziiert ist; und
Senden des Index an den Server für föderiertes Lernen.

2. Verfahren nach Anspruch 1, wobei:
der Index unter Nutzung von log₂*K* Bits gesendet wird, und
*K* eine Anzahl der Vielzahl von Zufallsstichproben aus der ersten Wahrscheinlichkeitsverteilung ist.

3. Verfahren nach Anspruch 1, wobei die Vielzahl von Zufallsstichproben mit einer Schicht des globalen Modells assoziiert ist.

4. Verfahren nach Anspruch 1, wobei die Vielzahl von Zufallsstichproben mit einem Subsatz von Parametern des globalen Modells assoziiert ist.

5. Verfahren nach Anspruch 1, das weiter Folgendes aufweist:
Beschneiden bzw. Zurechtstutzen des aktualisierten Modells vor Bestimmen der zweiten Wahrscheinlichkeitsverteilung, die auf das aktualisierte Modell zentriert ist,
wobei Beschneiden auf einer Standardabweichung des globalen Modells basiert, und
wobei die zweite Wahrscheinlichkeitsverteilung auf dem beschnittenen aktualisierten Modell basiert.

6. Verfahren nach Anspruch 5, wobei Beschneiden des aktualisierten Modells Beschneiden einer Norm des aktualisierten Modells aufweist.

7. Verfahren nach Anspruch 1, wobei Bestimmen des aktualisierten Modells basierend auf dem globalen Modell und lokalen Daten Durchführen eines Gradientenabstiegs bzw. Gradient-Descent auf dem globalen Modell unter Nutzung der lokalen Daten aufweist.

8. Ein computerimplementiertes Verfahren (900), das Folgendes aufweist:
Senden (902) eines globalen Modells an eine Client-Einrichtung;
Bestimmen (904) eines Zufalls-Seeds, was Empfangen des Zufalls-Seeds von der Client-Einrichtung aufweist;
Empfangen (906) eines aktualisierten Modells von der Client-Einrichtung unter Nutzung einer relativen Entropiecodierung; und
Bestimmen (908) eines aktualisierten globalen Modells basierend auf dem aktualisierten Modell von der Client-Einrichtung,
wobei Empfangen des aktualisierten Modells von der Client-Einrichtung unter Nutzung einer relativen Entropiecodierung Folgendes aufweist:
Empfangen eines Index von der Client-Einrichtung;
Bestimmen einer Stichprobe aus einer Wahrscheinlichkeitsverteilung basierend auf dem globalen Modell, dem Zufalls-Seed und dem Index; und
Nutzen der bestimmten Stichprobe zum Bestimmen des aktualisierten globalen Modells, wobei die bestimmte Stichprobe zum Aktualisieren eines Parameters des aktualisierten globalen Modells verwendet wird.

9. Verfahren nach Anspruch 8, wobei:
der Index unter Nutzung von log₂*K* Bits empfangen wird, und
*K* eine Anzahl von Zufallsstichproben ist, die aus einer Wahrscheinlichkeitsverteilung basierend auf dem globalen Modell bestimmt werden.

10. Verfahren nach Anspruch 8, wobei die bestimmte Stichprobe zum Aktualisieren einer Schicht des aktualisierten globalen Modells genutzt wird.

11. Ein Verarbeitungssystem zum Durchführen föderierten Lernens, das Mittel aufweist, um das Verarbeitungssystem zu Veranlassen zum Durchführen eines Verfahrens nach einem der Ansprüche 1 bis 10.

12. Verarbeitungssystem nach Anspruch 11, das Folgendes aufweist: einen Speicher, der von einem Computer ausführbare Anweisungen aufweist; und einen oder mehrere Prozessoren, die konfiguriert sind, die von einem Computer ausführbaren Anweisungen auszuführen und zu veranlassen, dass das Verarbeitungssystem das Verfahren durchführt.

13. Ein nichtflüchtiges computerlesbares Medium, das von einem Computer ausführbare Instruktionen aufweist, die, wenn sie durch einen oder mehrere Prozessoren eines Verarbeitungssystems ausgeführt werden, bewirken, dass das Verarbeitungssystem ein Verfahren nach einem der Ansprüche 1 bis 10 durchführt.

14. Ein Computerprogrammprodukt, das Code zum Durchführen eines Verfahrens nach einem der Ansprüche 1 bis 10 aufweist.

## Revendications

1. Procédé mis en œuvre par ordinateur (800), comprenant :
la réception (802) d'un modèle global en provenance d'un serveur d'apprentissage fédéré ;
la détermination (804) d'un modèle mis à jour basé sur le modèle global et des données locales ; et
l'envoi (806) du modèle mis à jour au serveur d'apprentissage fédéré en utilisant un codage à entropie relative ;
dans lequel l'envoi du modèle mis à jour au serveur d'apprentissage fédéré en utilisant un codage à entropie relative comprend :
la détermination d'une graine aléatoire comprenant la réception de la graine aléatoire en provenance du serveur d'apprentissage fédéré ;
la détermination d'une première distribution de probabilité basée sur le modèle global ;
la détermination d'une deuxième distribution de probabilité centrée sur le modèle mis à jour ;
la détermination d'une pluralité d'échantillons aléatoires à partir de la première distribution de probabilité selon la graine aléatoire sur la base d'une différence entre la première distribution de probabilité et la deuxième distribution de probabilité, dans lequel la pluralité d'échantillons aléatoires est associée à une pluralité de paramètres du modèle global ;
l'attribution d'une probabilité à chaque échantillon aléatoire respectif parmi la pluralité d'échantillons aléatoires sur la base d'un rapport d'une vraisemblance de l'échantillon aléatoire respectif étant donné la deuxième distribution de probabilité sur une vraisemblance de l'échantillon aléatoire respectif étant donné la première distribution de probabilité ;
la sélection d'un échantillon aléatoire parmi la pluralité d'échantillons aléatoires en fonction de la probabilité de chacun des échantillons aléatoires parmi la pluralité d'échantillons aléatoires ;
la détermination d'un index associé à l'échantillon aléatoire sélectionné ; et
l'envoi de l'index au serveur d'apprentissage fédéré.

2. Procédé selon la revendication 1, dans lequel :
l'index est envoyé en utilisant log2K bits, et
K est un nombre parmi la pluralité d'échantillons aléatoires déterminés à partir de la première distribution de probabilité.

3. Procédé selon la revendication 1, dans lequel la pluralité d'échantillons aléatoires sont associés à une couche du modèle global.

4. Procédé selon la revendication 1, dans lequel la pluralité d'échantillons aléatoires sont associés à un sous-ensemble de paramètres du modèle global.

5. Procédé selon la revendication 1, comprenant en outre :
le découpage du modèle mis à jour avant la détermination de la deuxième distribution de probabilité centrée sur le modèle mis à jour,
dans lequel le découpage est basé sur un écart type du modèle global, et
dans lequel la deuxième distribution de probabilité est basée sur le modèle mis à jour découpé.

6. Procédé selon la revendication 5, dans lequel le découpage du modèle mis à jour comprend le découpage d'une norme du modèle mis à jour.

7. Procédé selon la revendication 1, dans lequel la détermination du modèle mis à jour basé sur le modèle global et des données locales comprend l'exécution d'une descente de gradient sur le modèle global en utilisant les données locales.

8. Procédé mis en œuvre par ordinateur (900), comprenant :
l'envoi (902) d'un modèle global à un dispositif client ;
la détermination (904) d'une graine aléatoire comprenant la réception de la graine aléatoire en provenance du dispositif client ;
la réception (906) d'un modèle mis à jour en provenance du dispositif client en utilisant un codage à entropie relative ; et
la détermination (908) d'un modèle global mis à jour sur la base du modèle mis à jour en provenance du dispositif client,
dans lequel la réception du modèle mis à jour en provenance du dispositif client en utilisant un codage à entropie relative comprend :
la réception d'un index en provenance du dispositif client ;
la détermination d'un échantillon à partir d'une distribution de probabilité basée sur le modèle global, la graine aléatoire et l'index ; et
l'utilisation de l'échantillon déterminé pour déterminer le modèle global mis à jour, dans lequel l'échantillon déterminé est utilisé pour mettre à jour un paramètre du modèle global mis à jour.

9. Procédé selon la revendication 8, dans lequel :
l'index est reçu en utilisant log2K bits, et
K est un nombre d'échantillons aléatoires déterminés à partir d'une distribution de probabilité basée sur le modèle global.

10. Procédé selon la revendication 8, dans lequel l'échantillon déterminé est utilisé pour mettre à jour une couche du modèle global mis à jour.

11. Système de traitement destiné à exécuter un apprentissage fédéré comprenant des moyens pour amener le système de traitement à exécuter un procédé selon l'une quelconque des revendications 1 à 10.

12. Système de traitement selon la revendication 11, comprenant : une mémoire comprenant des instructions exécutables par ordinateur ; et un ou plusieurs processeurs configurés pour exécuter les instructions exécutables par ordinateur et amener le système de traitement à exécuter le procédé.

13. Support non transitoire lisible par ordinateur comprenant des instructions exécutables par ordinateur qui, lorsqu'elles sont exécutées par un ou plusieurs processeurs d'un système de traitement, amènent le système de traitement à exécuter un procédé selon l'une quelconque des revendications 1 à 10.

14. Produit programme d'ordinateur comprenant un code pour exécuter un procédé selon l'une quelconque des revendications 1 à 10.
